# EUROPÄISCHE PATENTANMELDUNG

(11) **EP 2 105 241 A2**
(43) Veröffentlichungstag der Anmeldung: **30.09.2009**
(21) Anmeldenummer: 09003164.2
(22) Anmeldetag: 05.03.2009
(51) Int. Cl.: B23K 26/40, B23K 26/06, B23K 26/00, H01L 31/18, H01L 27/142

(54) **Verfahren zur Strukturierung der Zinkoxid-Frontelektrodenschicht eines photovoltaischen Moduls**

(30) Priorität: 27.03.2008 DE 102008015807
(71) Anmelder: SCHOTT Solar AG, 55122 Mainz (DE)
(72) Erfinder: Psyk, Walter, 81371 München (DE)
(74) Vertreter: Haft, von Puttkamer, Berngruber

(57) **Zusammenfassung**

Zur Strukturierung einer auf einem transparenten elektrisch isolierenden Substrat (2) abgeschiedenen Frontelektrodenschicht (3) aus Zinkoxid bei der Herstellung eines photovoltaischen Moduls (1) wird ein gepulster Festkörperlaser (13) mit einer kurzen Pulsbreite verwendet, der eine infrarote Strahlung emittiert.

## Beschreibung

Die Erfindung bezieht sich auf ein Verfahren zur Strukturierung einer auf einem transparenten, elektrisch isolierenden Substrat abgeschiedenen Frontelektrodenschicht aus Zinkoxid mit einem Festkörperlaser bei der Herstellung eines photovoltaischen Moduls nach dem Oberbegriff des Anspruchs 1.

Bei der Herstellung eines photovoltaischen Moduls werden auf dem transparenten, elektrisch isolierenden Substrat, beispielsweise einer Glasscheibe, drei Funktionsschichten, nämlich eine transparente Frontelektrodenschicht, eine Halbleiterdünnschicht und eine Rückelektrodenschicht großflächig abgeschieden.

Um aus diesen monolithischen Schichten serienverschaltete Zellen zu bilden, werden die Schichten z. B. mit einem Laser, mechanischen Verfahren oder auf chemischem Wege durch Trennlinien strukturiert.

Die Trennlinien oder Gräben zur Strukturierung der Frontelektrodenschicht werden im allgemeinen durch Laserstrahlung erzeugt. Somit wird die ursprünglich monolithische Frontelektrodenschicht in einzelne Streifen separiert, die elektrisch voneinander getrennt sind.

Die Frontelektrodenschicht besteht aus einem transparenten, elektrisch leitfähigen Metalloxid, beispielsweise Zinkoxid (ZnO) oder Zinnoxid (SnO₂).

Da Zinnoxid Laserlicht im infraroten Bereich absorbiert, wird die Zinnoxid-Frontelektrodenschicht typischerweise mit einem Neodym dotiertem Yttrium-Aluminium-Granat (Nd:YAG)- oder einem Neodym dotierten Yttrium-Vanadat(Nd:YVO₄)-Festkörperlaser strukturiert, der eine infrarote Strahlung mit einer Wellenlänge von 1064 nm emittiert.

Demgegenüber absorbiert Zinkoxid nur Laserlicht im ultraviolettem Bereich, sodass für die Strukturierung einer Zink-Frontelektrodenschicht typischerweise ein Nd:YAG- oder ein Nd:YVO₄-Festkörperlaser mit der dritten harmonischen Frequenz mit einer Wellenlänge von 355 nm verwendet wird, also ein Laser, der Laserlicht im UV-Bereich emittiert.

Die Strukturierung der Halbleiterschicht, beispielsweise eine Siliziumdünnschicht, erfolgt ebenfalls typischerweise mit Lasertechnik. Dabei wird ein Nd:YAG- oder Nd:YVO₄-Festkörperlaser mit der zweiten harmonischen Frequenz mit einer Wellenlänge von 532 nm eingesetzt, da die Siliziumdünnschicht gegenüber der transparenten Frontelektrodenschicht bei dieser Wellenlänge ein hohes optisches Absorptionsvermögen besitzt.

Für die Strukturierung der Rückelektrodenschicht werden mechanische Verfahren (Lift-Off-Technik) sowie auch Laserverfahren eingesetzt. Bei dem mechanischen Verfahren wird z. B. ein Medium auf die Halbleiterschicht aufgebracht, das die Halbleiterschicht beim anschließenden Beschichten der Rückelektrodenschicht maskiert. In dem folgenden Lift-Off-Prozess wird das maskierende Medium mit der darüber liegenden Rückelektrodenschicht mechanisch, beispielsweise mit einem Wasserstrahl, entfernt. Somit ist die Rückelektrodenschicht in einzelne Streifen separiert. Die Strukturierung der Rückelektrodenschicht kann aber auch mit einem Laser erfolgen. Typischerweise werden für die Strukturierung der Rückelektrodenschicht Nd:YAG- oder Nd:YVO₄-Festkörperlaser mit der zweiten harmonischen Frequenz (532 nm) eingesetzt.

Da Neodym dotierte Festkörperlaser der dritten harmonischen Frequenz gegenüber Neodym dotierten Festkörperlasern mit der Grundwellenlänge von 1064 nm mit wesentlich höheren Kosten verbunden sind, ist die Laserstrukturierung einer Zinkoxid-Frontelektrodenschicht um ein Vielfaches teurer als die einer Frontelektrodenschicht aus Zinnoxid. Zudem muss der Festkörperlaser mit der dritten harmonischen Frequenz durch Neupositionierung des alternden Kristalls, der die dritte harmonische Frequenz erzeugt, regelmäßig gewartet werden.

Aufgabe der Erfindung ist es daher, die Kosten zur Strukturierung einer Frontelektrodenschicht aus Zinkoxid bei der industriellen Herstellung photovoltaischer Module wesentlich herabzusetzen.

Dies wird erfindungsgemäß dadurch erreicht, dass zur Strukturierung der Zinkoxid-Frontelektrodenschicht ein gepulster Laser mit einer kurzen Pulsbreite von weniger als 500 ns verwendet wird, der eine infrarote Strahlung emittiert.

Obgleich Zinkoxid (ZnO) Laserlicht im infraroten Bereich nicht absorbiert, lässt sich die auf dem transparentem Substrat, beispielsweise einer Glasscheibe, abgeschiedene Zinkoxid-Schicht überraschenderweise mit den kurzen Laserpulsen eines Infrarotlicht emittierenden Lasers strukturieren, insbesondere, wenn der Laserstrahl zur Strukturierung der Frontelektrodenschicht durch das transparente Substrat hindurch auf die Frontelektrodenschicht fokussiert wird. Durch die kurze Pulsbreite der Laserpulse wird die Laserleistung zunächst an der Grenzfläche zwischen dem transparenten Substrat und der Zinkoxid-Schicht deponiert. Ein gewisser Anteil des Zinkoxid-Materials an dieser Grenzfläche wird durch die Laserleistung verdampft, während die übrige Laserleistung das Zinkoxid teilweise aufschmilzt. Durch den Dampfdruck wird dann das im Laserfokus erhitzte Zinkoxidmaterial von der Substratoberfläche weggesprengt, jedenfalls mechanischthermisch entfernt.

Das bei der Strukturierung der Frontelektrodenschicht entfernte Zinkoxid-Abraummaterial wird vorzugsweise mit einer Laserstaubabsaugeinrichtung abgesaugt, die es zu einer Filteranlage transportiert. Damit wird das Zinkoxid in den mit dem Laser erzeugten Trennlinien oder Gräben entfernt bzw. abladiert und die ursprünglich monolithische Zinkoxidschicht in einzelne, mechanisch und elektrisch voneinander getrennte Streifen unterteilt.

Dabei hat es sich als notwendig erwiesen, kurzpulsige Laser mit einer Pulsbreite von weniger als 500 ns für die Strukturierung der Zinkoxid-Frontelektrodenschicht einzusetzen, die eine infrarote Strahlung emittieren. So schmelzen Nd:YAG-Laser mit größeren Pulsbreiten von bis zu 900 ns das Zinkoxidmaterial zwar auf, entfernen dieses aber nicht rückstandsfrei aus der Trennlinie.

Der erfindungsgemäß eingesetzte Laser emittiert eine Infrarotstrahlung, also eine Strahlung mit einer Wellenlänge von mindestens 800 nm, vorzugsweise 1000 nm und mehr, insbesondere wird ein im nahen Infrarotbereich emittierender Festkörperlaser verwendet. Der Festkörperlaser kann auch ein Faserlaser oder ein Scheibenlaser sein.

Vorzugsweise ist der Festkörperlaser ein Yttrium-Vanadat (YVO₄) -Laser. Statt dessen kann der Wirtskristall beispielsweise auch YAG sein. Zur Dotierung wird vorzugsweise Neodym verwendet, also ein Festkörperlaser mit einer Wellenlänge von 1064 nm eingesetzt. Gegebenenfalls kann auch Erbium, Ytterbium oder ein anderes Element zur Dotierung des Lasers verwendet werden. Ein Neodym dotierter Yttrium-Vanadat-Laser (Nd:YVO₄-Laser) oder ein Neodym dotierter YAG-Laser (Nd:YAG-Laser) wird besonders bevorzugt.

Die Pulsbreite der Pulse des gepulsten Lasers beträgt im allgemeinen weniger als 200 ns. So kann zur Strukturierung der Zinkoxid-Frontelektrodenschicht beispielsweise ein Nd:YVO₄-Festkörperlaser mit einer Grundwellenlänge von 1064 nm mit Pulsbreiten von 1 bis 50 ns, insbesondere 5 bis 20 ns verwendet. Auch können so genannte Long-Puls-YVO₄-Festkörperlaser mit einer Pulsbreite von bis zu ca. 100 ns für die Strukturierung eingesetzt werden. Die Laserstrahlung des Nd:YVO₄-Festkörperlasers mit seiner Grundwellenlänge von 1064 nm wird idealerweise durch das transparente Substrat auf die Zinkoxidschicht fokussiert. Alternativ kann die Laserstrahlung aber auch direkt auf die Zinkoxid-Frontelektrodenschicht fokussiert werden.

Erfindungsgemäß können damit in der Zinkoxid-Frontelektrodenschicht schmale, also beispielsweise 10 bis 100 µm breite Trennlinien erzeugt werden, um die für die integrierte Serienverschaltung elektrisch voneinander separierten Solarzellen herzustellen.

Die Strukturierung der Zinkoxid-Frontelektrodenschicht beispielsweise mit der Grundwelle des Nd:YVO₄-Lasers erfolgt vorzugsweise in Güte geschalteten Betrieb (Quality-Switch-Mode). Die in die Zinkoxidschicht deponierte Laserleistung kann so gesteuert werden, dass das Zinkoxid in den Trennlinien ohne Beschädigung des Substrats, also beispielsweise der Glasscheibe entfernt werden kann.

Nachstehend ist die Erfindung anhand der Zeichnung beispielhaft näher erläutert. Darin zeigen jeweils schematisch und im Schnitt
Figur 1 ein photovoltaisches Modul;
Figur 2a und 2b die Herstellung der strukturierten Zinkoxid-Frontelektrodenschicht des Moduls; und
Figur 3 die Serienverschaltung der Einzelzellen C₁ und C₂ nach Figur 1.

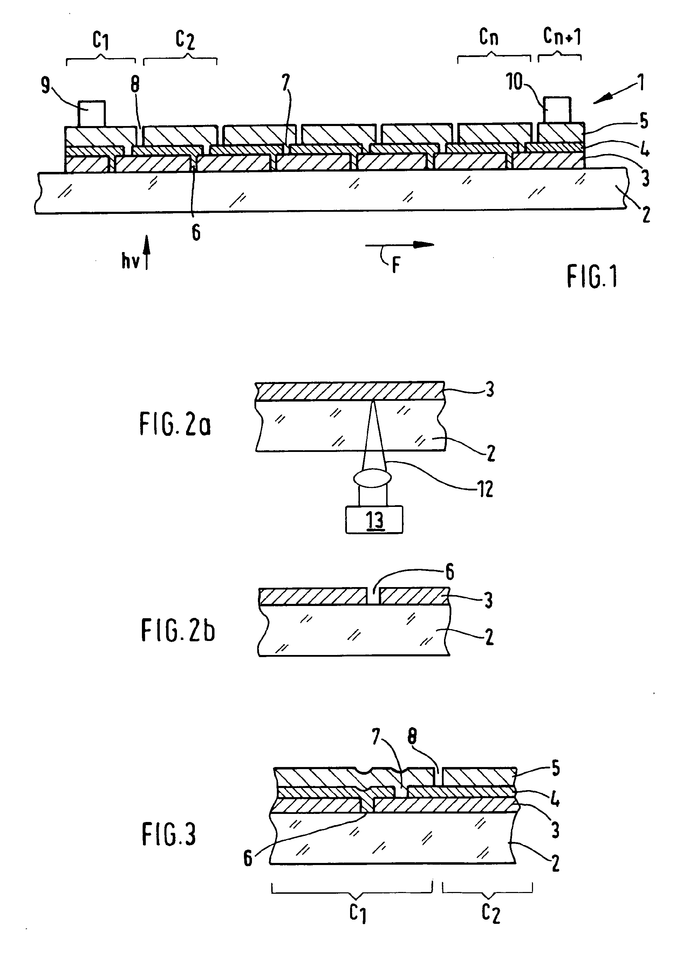

Gemäß Figur 1 weist das photovoltaische Modul 1 ein transparentes Substrat 2, beispielsweise eine Glasscheibe auf, auf der die drei Funktionsschichten, nämlich eine transparente Frontelektrodenschicht 3, eine Halbleiterdünnschicht 4 und eine Rückelektrodenschicht 5 aufeinander abgeschieden sind.

Das Modul 1 besteht aus einzelnen streifenförmigen Zellen C₁, C₂, ... Cₙ, Cₙ₊₁, die serienverschaltet sind und senkrecht zur Stromflussrichtung F verlaufen. Dazu ist die Frontelektrodenschicht 3 durch Trennlinien 6, die Halbleiterschicht 4 durch Trennlinien 7 und die Rückelektrodenschicht 5 durch Trennlinien 8 unterbrochen und damit strukturiert.

Gemäß Figur 1 kontaktiert die Rückelektrodenschicht 5 einer Zelle C₁, Cₙ damit durch die Trennlinie 7 in der Halbleiterschicht 4 die Frontelektrodenschicht 3 der benachbarten Zelle C₂, Cₙ₊₁, wodurch der Minuspol einer Zelle C₁, Cₙ mit dem Pluspol der benachbarten Zelle C₂, Cₙ₊₁ verbunden wird.

Der von dem photovoltaischen Modul 1 erzeugte Strom wird durch die Kontakte 11, 12 an den äußersten Zellen C₁, Cₙ₊₁ abgenommen. An der Rückseite des Moduls 1 mit den Kontakten 11, 12 ist noch ein nicht dargestellter Rückseitenschutz aus Kunststoff oder einem anderen elektrisch isolierendem Material vorgesehen.

In Figur 3 ist am Beispiel der Zellen C₁ und C₂ nach Figur 1 die Serienverschaltung zweier benachbarter Zellen dargestellt.

Die serienverschalteten Zellen C₁ und C₂ werden wie folgt hergestellt.

Ausgehend von einem mit Zinkoxid als Frontelektrodenschicht 3 beschichteten Glassubstrat 2 werden gemäß Figur 2a mit dem fokussierten Laserstrahl 12 des gepulsten Lasers 13, der eine Infrarotstrahlung emittiert, insbesondere einem Nd:VO₄-Laser mit einer Wellenlänge von 1064 nm und einer Pulsbreite zwischen 5 und 20 ns gemäß Figur 2b die Trennlinien 6 zur Strukturierung der Frontelektrodenschicht 3 erzeugt, und zwar durch Schmelzen und Verdampfen des Zinkoxids, durch die an der Grenzfläche Glassubstrat 2/Zinkoxidschicht 3 deponierte Laserleistung. Der Laserstrahl 12 wird dabei durch das Glassubstrat 2 hindurch auf die Frontelektrodenschicht 3 fokussiert. Dadurch werden Trennlinien 6 mit einer Breite von beispielsweise etwa 50 µm erzeugt.

Auf der so strukturierten Frontelektrodenschicht 3 wird anschließend die Halbleiterschicht 4, beispielsweise aus amorphem, nano-, mikro- oder polykristallinem Silizium oder einem anderen Halbleiter, beispielsweise Kadmium-Tellur, abgeschieden, die ihrerseits mit den Trennlinien 7 strukturiert wird, worauf die vorzugsweise metallische Rückelektrodenschicht 5 abgeschieden wird, die dann ihrerseits mit den Trennlinien 8 strukturiert wird.

## Patentansprüche

1. Verfahren zur Strukturierung einer auf einem transparenten elektrisch isolierenden Substrat (2) abgeschiedenen Frontelektrodenschicht (3) aus Zinkoxid mit einem Festkörperlaser (13) zur Herstellung eines photovoltaischen Moduls (1), das auf der Frontelektrodenschicht (3) eine Halbleiterschicht (4) und eine Rückelektrodenschicht (5) aufweist, die ihrerseits strukturiert sind, um mit der strukturierten Frontelektrodenschicht (3) serienverschaltete Zellen (C₁, C₂, ... Cₙ, Cₙ₊₁) zu bilden, **dadurch gekennzeichnet, dass** zur Strukturierung der Frontelektrodenschicht (3) ein gepulster Laser (13) mit einer kurzen Pulsbreite von weniger als 500 ns verwendet wird, der eine infrarote Strahlung emittiert.

2. Verfahren nach Anspruch 1, **dadurch gekennzeichnet, dass** die Pulsbreite des Lasers (13) weniger als 200 ns beträgt.

3. Verfahren nach Anspruch 1, **dadurch gekennzeichnet, dass** die Pulsbreite weniger als 50 ns beträgt.

4. Verfahren nach Anspruch 1, **dadurch gekennzeichnet, dass** die Pulsbreite des Lasers (13) weniger als 20 ns beträgt.

5. Verfahren nach Anspruch 1, **dadurch gekennzeichnet, dass** die Pulsung im Güte geschalteten Betrieb erfolgt.

6. Verfahren nach Anspruch 1, **dadurch gekennzeichnet, dass** ein Neodym dotierter Festkörperlaser mit einer Wellenlänge von 1064 nm verwendet wird.

7. Verfahren nach Anspruch 6, **dadurch gekennzeichnet, dass** ein Neodym dotierter Yttrium-Vanadat- oder Yttrium-Aluminium-Granat-Laser verwendet wird.

8. Verfahren nach Anspruch 1, **dadurch gekennzeichnet, dass** der Laserstrahl (12) zur Strukturierung der Frontelektrodenschicht (3) durch das transparente Substrat (2) auf die Frontelektrodenschicht (3) fokussiert wird.

9. Verfahren nach Anspruch 1, **dadurch gekennzeichnet, dass** das bei der Strukturierung der Frontelektrodenschicht (3) entfernte Zinkoxid-Abraummaterial abgesaugt wird.
